(19) Europäisches Patentamt
European Patent Office
Office européen des brevets

(11) **EP 3 029 674 B1**

(12) **EUROPEAN PATENT SPECIFICATION**

(45) Date of publication and mention
of the grant of the patent:
**30.01.2019 Bulletin 2019/05**

(51) Int Cl.:
*G11B 20/10* $^{(2006.01)}$   *H03H 17/02* $^{(2006.01)}$
*G10L 19/26* $^{(2013.01)}$

(21) Application number: **14196063.3**

(22) Date of filing: **03.12.2014**

(54) **Mastering improvements to audio signals**

Masteringverbesserungen an Audiosignalen

Améliorations de matriçage en signaux audio

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**08.06.2016 Bulletin 2016/23**

(73) Proprietors:
• **REINET S.À.R.L.**
  **1274 Luxembourg (LU)**
• **Craven, Peter Graham**
  **Haslemere**
  **Surrey GU27 2PT (GB)**

(72) Inventors:
• **Craven, Peter Graham**
  **London, SW19 3AR (GB)**
• **Stuart, John Robert**
  **Cambridge, Cambridgeshire CB3 0DP (GB)**

(74) Representative: **Gill Jennings & Every LLP
The Broadgate Tower
20 Primrose Street
London EC2A 2ES (GB)**

(56) References cited:
**WO-A1-2014/108677     US-A- 5 808 574
US-A1- 2009 027 117**

• **Anonymous: "bandpass - All-pass filters to
remedy group delay - Signal Processing Stack
Exchange", , 3 October 2012 (2012-10-03),
XP55355578, Retrieved from the Internet:
URL:http://dsp.stackexchange.com/questions
/3541/all-pass-filters-to-remedy-group-del
ay/15255 [retrieved on 2017-03-16]**

## Description

### Field of the Invention

The invention relates to the processing of audio signals prior to commercial distribution for improved sound quality as heard by the consumer, and particularly to reducing the audible effect of pre-responses.

### Background to the Invention

Until approximately 1995, the 44.1 kHz sampling rate of the Compact Disc (CD) was regarded by most people as entirely adequate. Since 1995, the 'hi-res' movement has adopted sampling frequencies of 96 kHz, 192 kHz or higher, potentially allowing audio bandwidths of 40 kHz, 80 kHz or more. It has always been something of a puzzle as to why there should be any audible advantage in the bandwidth extension, since the CD's sampling rate of 44.1 kHz allows near-perfect reproduction of audio frequencies up to 20 kHz, the generally-accepted upper frequency limit of human hearing.

Superior time-resolution has been advanced as a possible explanation of the apparent paradox, and a recent paper by J.R. Stuart and P.G. Craven "A Hierarchical Approach to Archiving and Distribution" presented at the Audio Engineering Society Convention, Los Angeles, 11th October 2014 [AES preprint no. 9178], explains this concept and cites several Neuroscience references that support this view.

According to this view, the impulse response of a recording and reproduction chain should be as compact in time as possible. Experience indicates that pre-responses are particularly undesirable and the above-cited reference presents an argument as to why this might be the case.

The many existing recordings stored at 44.1 kHz have generally either been made using an oversampling analogue-to-digital converter providing a 44.1 kHz output, or they have been explicitly downsampled from a recording made at a higher sampling rate. Filtering is required in both cases and until recently it was generally considered better to use linear phase filtering. Unfortunately, linear phase filtering always introduces pre-responses.

In the case of recordings made at sample rates such as 88.2kHz or higher, the pre-response can be reduced by "Apodising" as described in Craven, P.G., "Antialias Filters and System Transient Response at High Sample Rates" J. Audio Eng. Soc. Volume 52 Issue 3 pp. 216-242; March 2004.

Typically an 88.2 kHz sampled system will have an antialias filter that cuts steeply at 40 kHz or some slightly higher frequency. The solution proposed in the paper is to 'apodise', that is to filter more gently starting at 20kHz or a slightly higher and tapering down to zero by about 40 kHz. The sharp band-edge above 40 kHz is thereby rendered innocuous, since the apodising filter has removed the signal energy at frequencies that would provoke ringing or pre-responses. There remains some pre-and/or post-response from the apodising filter itself, but this can be much shorter in time since its transition band, from 20 kHz to 40 kHz, is much wider.

The situation is much less favourable for 44.1 kHz recordings. For these recordings it has generally been considered ideal to use a downsampling or antialias filter with a response flat to 20 kHz and then cutting sharply to be essentially zero by the Nyquist frequency of 22.05 kHz. It is thus not possible for an apodising filter to taper the response gently to zero by the frequency of the sharp-cut filter unless the apodising filter starts to taper at a lower frequency such as 15 kHz, which is not generally considered acceptable. Sometimes it is possible to improve the sound by a filter that begins to roll off at 20 kHz but in general there is a danger that an apodiser constrained thus will simply replace one band-edge by another nearly as sharp and at a slightly lower frequency.

What is needed therefore is an improved or alternative technique to minimise the undesirable audible effects of pre-responses, especially for signals that have been stored or will be transmitted at a relatively low sampling rate such as 44.1 kHz. WO2014/108677A1 describes encoding and decoding systems for the provision of high quality digital representations of audio signals with particular attention to the correct perceptual rendering of fast transients at modest sample rates. This is achieved by optimising downsampling and upsampling filters to minimise the length of the impulse response while adequately attenuating alias products that have been found perceptually harmful.

US5808574A describes an electronic method and apparatus for signal encoding and decoding to provide ultra-low distortion reproduction of analog signals, while remaining compatible with industry standardized signal playback apparatus not incorporating the decoding features of the method and apparatus.

US2009/0027117A1 describes systems and methods for performance improvements in digital switching amplifiers using low-pass filtering to reduce noise and distortion, and particularly for digital pulse width modulation (PWM) amplifiers.

### Summary of the Invention

According to a first aspect of the present invention, there is provided a method of reducing a pre-response having energy at a pre-response frequency, the method comprising the step of filtering a digital audio signal using a digital non-minimum-phase filter having a z-transform response that includes a zero lying outside the unit circle, wherein the zero is selected to create a greater group delay at the pre-response frequency than at a frequency of 0 Hz.

The inventors have realised that a pre-response can be substantially converted into a post-response using a filter whose group delay is larger at frequencies where the pre-responses has most energy. The inventors have further realised that a non-minimum-phase filter, namely a filter whose z-transform response has a zero lying outside the unit circle, is particularly useful in this respect. The zero may be selected to create a greater group delay at the pre-response frequency than at low frequencies generally, and more specifically at a frequency of 0 Hz.

A zero outside the unit circle introduces a 'maximum phase' element into the filter's transfer function, the resulting group delay thereby delaying the pre-response so that it becomes closer to the main peak of the impulse response and thereby less audible. With several such zeroes acting co-operatively, the pre-response may be transformed into a post-response, which is much less audible.

Signals retrieved from an archive may contain a pre-response already, in which case the invention will delay the existing pre-response. Alternatively, or in addition, a pre-response-generating operation may occur at a later stage of signal processing. In that case filtering according to the invention will pre-emptively delay the signal frequency components that would provoke the pre-response, delaying also the pre-response relative to lower-frequency components of the signal. The two situations are mathematically identical since linear filtering is a commutative operation.

Typically, pre-responses are caused by filtering operations performed in connection with a change of sample rate, it being usual to apply a steep-cut filter at a frequency just below a 'reference' Nyquist frequency corresponding to a 'reference' sample rate, being the lower of the sample rates involved. A pre-response thereby generated can be expected to have energy that lies predominantly within 20% of the said reference Nyquist frequency.

The method may be performed using a filter having many z-plane zeroes but the inventors have found that often a significant audible advantage may be obtained using a filter having as few as three zeroes outside the unit circle, each having the group delay properties referred to above. Specifically, if 'z' represents a time advance of one sample at a sampling frequency equal to twice the reference Nyquist frequency, it is preferred that the filter comprise at least three z-plane zeroes having reciprocals whose real parts are more negative than -0.5.

In some embodiments, the method of the invention will be applied to a signal that has been downsampled from a higher frequency. In that case the reference sample rate is the sampling frequency of the digital audio signal.

Sometimes it is convenient to apply the method to a signal that has already been upsampled by a factor of two, or alternatively to a signal that will subsequently be downsampled by a factor of two. In that case, the reference sample rate is one half of the sampling frequency of the digital audio signal and the filter should be configured to delay pre-responses close to a reference Nyquist frequency that is one quarter of the sampling frequency of the digital audio signal.

A z-plane zero close to a Nyquist frequency will create an amplitude response that is severely depressed in the vicinity of the Nyquist frequency. The amplitude response may be flattened completely by incorporating also a pole at a reciprocal position in the z-plane, the zero and the pole in combination forming an all-pass factor in the filter's transfer function.

Alternatively, the amplitude response may be flattened approximately by adding poles having frequencies slightly lower than the zeroes, the poles being configured to provide an amplitude response flat within a tolerance such as 1dB over a frequency range important to the ear, such as 0 to 16 kHz.

According to a second aspect of the present invention there is provided a mastering processor adapted to receive a first digital audio signal and to furnish a second digital audio signal for distribution, wherein the mastering processor is configured to perform the method of the first aspect of the invention to reduce a pre-response in a signal rendered from the second signal for auditioning by a listener.

Thus, the method of the first aspect is performed by a mastering processor that receives audio 'tracks' from an archive and adjusts them prior to commercial release. Often, tracks within the archive will have pre-responses, which the method delays in order to reduce their audible effect. The method may also pre-emptively delay pre-responses produced by upsampling or downsampling in listeners' equipment.

According to a third aspect of the present invention there is provided a consumer equipment having an input adapted to receive a digital audio signal, the consumer equipment configured to process the received digital audio signal according to the method of the first aspect of the invention.

In this way, equipment designed for home listening may perform the method of the first aspect to improve the sound quality from existing CDs and other sources that have not been mastered according to the invention. The equipment may also perform the method in order to precondition a digital audio signal prior to a digital-to-analogue conversion that may generate pre-responses.

It is noted that the invention may be embodied in hardware, such as custom logic built into an ADC or DAC, or in software, or in a combination of both.

According to a fourth aspect of the present invention there is provided a recorded medium conveying a digital audio signal processed by the method of the first aspect. Such a recording will have minimal inherent pre-responses and/or will reduce pre-responses that would otherwise be audible on reproduction.

According to a fifth aspect of the present invention there is provided a computer program product comprising instructions that when executed by a signal processor causes said signal processor to perform the method of the first aspect.

Such a program product may implement a digital signal processor (DSP) that performs the mastering behaviour of the invention. Alternatively, the program product may implement an upgrade to an existing DSP, which allows it to perform the mastering behaviour of the invention. A similar upgrade may be provided to the processing capability of end-user consumer equipment. Indeed, the invention may be implemented in software "apps" for mobile phones and the like, or in upgrades therefor. The ability to "retrofit" such an upgrade to existing equipment in order that it can implement the invention is a particularly advantageous feature.

As will be appreciated by those skilled in the art, the present invention provides methods and devices for reducing audible pre-responses in an audio signal, and which can do so by reducing existing pre-responses in an audio signal and/or by taking pre-emptive action in anticipation of pre-responses that would be introduced by subsequent processing. The pre-responses are effectively delayed by employing a digital non-minimum-phase filter, which includes a zero lying outside the unit circle in its z-transform response. Further variations and embellishments will become apparent to the skilled person in light of this disclosure.

**Brief Description of the Drawings**

Examples of the present invention will be described in detail with reference to the accompanying drawings, in which:

**Figure 1** illustrates schematically a complete recording and reproduction chain;

**Figure 2** shows (solid line) the transition band of the filter used by Adobe 'Audition 1.5' when downsampling from 88.2 kHz to 44.1 kHz, and (dashed line) the transition band of an Arcam FMJ DV139 player when playing a CD;

**Figure 3A** shows (upper trace) an impulse response of the Adobe downsampling filter of Figure 1, the time-axis referring to sample periods at an 88.2 kHz sampling rate, and (lower trace) an impulse response of the Arcam reconstruction filter of Figure 1;

**Figure 3B** shows more detail of the Adobe pre-responses of Figure 3A;

**Figure 3C** shows a spectrum of part of the Adobe pre-response of Figure 3A

**Figure 4A** shows the poles and zeroes of a 3rd order IIR low-pass filter;

**Figure 4B** shows the frequency response of the filter of Figure 4A;

**Figure 4C** shows (upper trace) Arcam impulse response, and (lower trace) Arcam impulse response with pre-processing by the 3rd order IIR low-pass filter of Figure 4A, both plotted with a 5× expanded vertical scale;

**Figure 5A** shows the poles and zeroes of a maximum-phase 3rd order IIR low-pass filter having the same frequency response as Figure 4B;

**Figure 5B** shows Arcam impulse responses with pre-processing (upper trace) by the 3rd order IIR low-pass filter of Figure 4A, and (lower trace) by the maximum-phase filter of Figure 5A, both plotted with a 10× expanded vertical scale;

**Figure 6A** shows the poles and zeroes of an all-pass filter having the same zeroes as the filter of Figure 5A;

**Figure 6B** shows a comparison between (upper trace) the 'Arcam' impulse response shown also in figure 3A; and (lower trace) the Arcam impulse response pre-processed by the all-pass filter of figure 6A, both plotted with a 5× expanded vertical scale;

**Figure 7A** shows the poles and most of the zeroes of a 12th-order all-pass filter, two of the zeroes being outside the range of the plot;

**Figure 7B** shows (top trace) impulse response of Adobe 'Audition 1.5' downsampling filter, (middle trace) impulse response of Adobe 'Audition 1.5' downsampling filter followed by the Arcam reconstruction filter, and (bottom trace) impulse response of Adobe 'Audition 1.5' downsampling filter followed by the 12th-order all-pass filter of Figure 7A followed by the Arcam reconstruction filter;

**Figure 8** shows group delays of (solid line) the 12th order all-pass filter of Figure 7A and (dashed line) the 3rd order all-pass filter of Figure 6A. The vertical axis is calibrated in sample periods at the 88.2 kHz sampling rate;

**Figure 9** shows group delays in sample periods of (full line) a single zero at z = - 1.5, i.e. at radius 1.5 and frequency 22.05 kHz, and (dashed lines) conjugate pairs of zeros at radius 1.5 and frequencies of 20 kHz, 16 kHz and 11.025 kHz;

**Figure 10A** shows the poles and most of the zeroes of the all-pass filter of Figure 7A modified for operation at a higher sample rate. Two of the zeroes are outside the range of the plot; and,

**Figure 10B** shows the group delay ($\tau$,) in sample periods of the all-pass filter of Figure 10A when operated at a sample rate of 88.2 kHz.

## Detailed Description

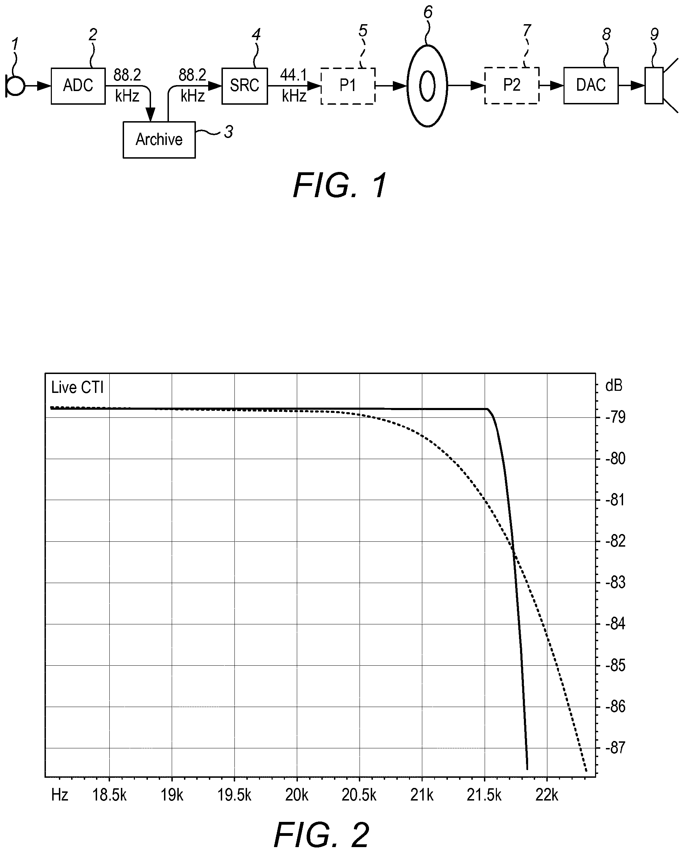

Figure 1 shows an example recording and reproduction chain in which a sound is captured by a microphone 1, converted to digital form by an analogue-to-digital-converter (ADC) 2 and the resulting signal stored in an archive 3. At some later time the signal is retrieved from the archive and may pass through a sample rate converter (SRC) 4 and further processing (P1) 5 before being distributed 6 to listeners either via a physical medium such as Compact Disc (CD) or by an intangible medium such as radio broadcasting or Internet transmission.

The listener's equipment 7, 8, 9 includes a digital to analogue converter (DAC) 8 and a transducer 9 such as a headphone or loudspeaker, and optionally further processing (P2) 7.

As will be described later, processing according to the invention may be provided either as P1 in the mastering equipment 5 or as P2 in the listener's receiving equipment 7. In both cases, pre-rings generated by the ADC 2 or the SRC 4 or by the listener's DAC 8 will be treated. In some implementations, processing according to the invention may be provided at both locations. Furthermore, in some embodiments, processing according to the invention may be provided before the SRC, if present, or even before the Archive.

The CD uses a sample rate of 44.1 kHz and throughout the 1980s and 1990s many companies operated the whole recording chain at 44.1 kHz, also archiving at 44.1 kHz so that the SRC 4 was not used. More recently there has been a tendency to run the ADC and the archive at a higher rate such as 44.1 kHz, 88.2 kHz, 176.4 kHz, 192 kHz, or even 2.8224 MHz for 1-bit 'DSD' recording, thus necessitating the sample rate converter 4, which can be either a separate piece of hardware or part of a software Digital Audio Workstation (DAW).

Sample rate conversion has a strong potential to generate pre-responses because of the necessary filtering. This problem is not evaded by running the whole chain at 44.1 kHz, for most commercial ADCs that furnish a 44.1 kHz output will operate internally at a higher frequency and then use a sample rate conversion process to provide the desired output sample rate.

Diverse architectures are known for sample rate conversion, the choice depending on factors such as whether the frequencies involved are in a simple integer ratio such as 2:1 or a more 'difficult' ratio such as 48:44.1. Alias-free downsampling to 44.1 kHz however always requires a low-pass filter that cuts quite sharply above 20 kHz. The requirements on the shape of the filter are not critically dependent on the sampling frequency of the source signal. This is true also for upsampling to an arbitrary new sample rate. Thus both downsampling and upsampling/reconstruction generate a requirement for a digital low-pass filter known as an 'antialias' filter when downsampling or as a 'reconstruction' filter when upsampling. The technical requirements for the two filters are not necessarily very different.

Opinion is divided on whether, when downsampling audio to 44.1 kHz or upsampling from 44.1 kHz, the low-pass filter should provide a substantial 'stop-band' attenuation such as 90dB at 22.05kHz or whether it acceptable to use a filter such as a 'half-band' operating at 88.2kHz and configured to provide 6dB attenuation at 22.05kHz and full attenuation by 24.1kHz. Historically, it was usual to make the filter's transition band as wide as was considered acceptable in order to minimise the number of taps in a hardware transversal ('FIR') implementation. The transition band was thus about 2 kHz wide, for example from 20 kHz to 22.05kHz, or alternatively about 4 kHz wide, for example from 20 kHz to 24.1 kHz. More recent software implementations have provided much narrower transition bands, for example the recent 'Adobe Audition CS 5.5' DAW offers SRC facilities having a transition band about 100Hz wide, starting about 75Hz below the Nyquist frequency.

Perhaps more typical is the earlier 'Adobe Audition 1.5' DAW which offers a filter having a transition band about 500Hz wide, starting at 21.5kHz. Many commercially issued recordings exhibit a near-Nyquist noise spectrum that suggests that a filter such as this may have been used at some stage in the processing. Figure 2 shows the Adobe filter's transition band and also the transition band of the analogue output of a well-regarded 'universal' disc player from Arcam when playing a 44.1 kHz CD. The Arcam response is about 6dB down at the Nyquist frequency, suggesting that an initial 1:2 upsampling may have been performed using a 'half-band' filter. Other plots of transition bands are shown in the "Sample Rate Conversion Comparison Project", currently accessible at

*http://infinitewave.ca/resources.htm.*

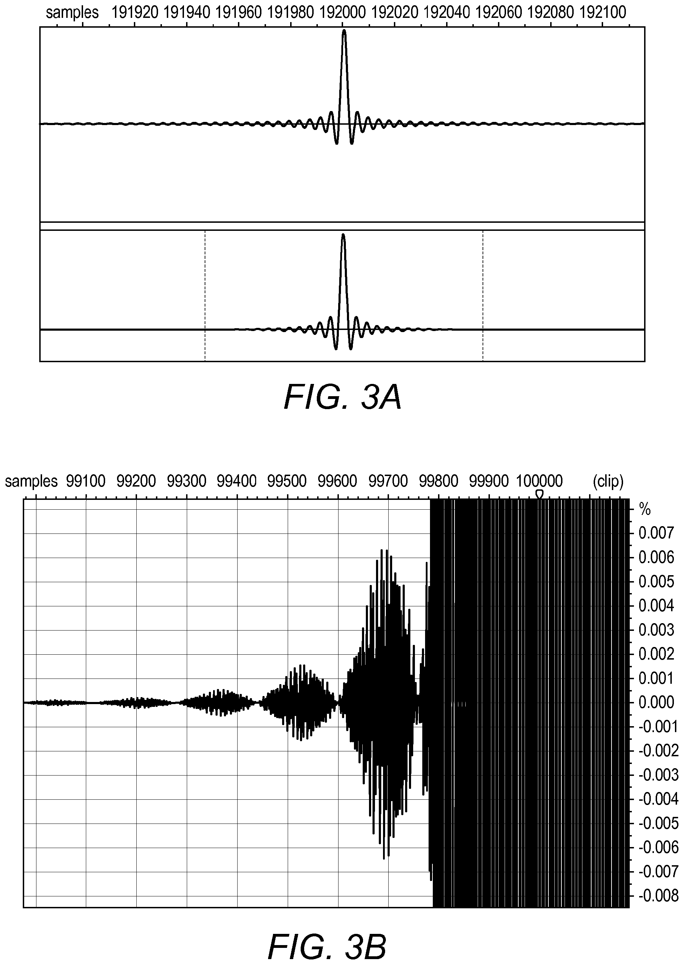

The impulse responses of the Adobe and Arcam filters are shown in figure 3A, each having a pre-ring and a post-ring approximately at the Nyquist frequency. The Adobe filter has the longer pre- and post- responses as might be expected from its narrower transition band. Close examination reveals that the Arcam response is essentially zero outside the region bounded by the two vertical lines, suggesting that a first upsampling from 44.1kHz to 88.2kHz has been performed using an FIR filter with a span of about 107 sample periods at 88.2kHz.

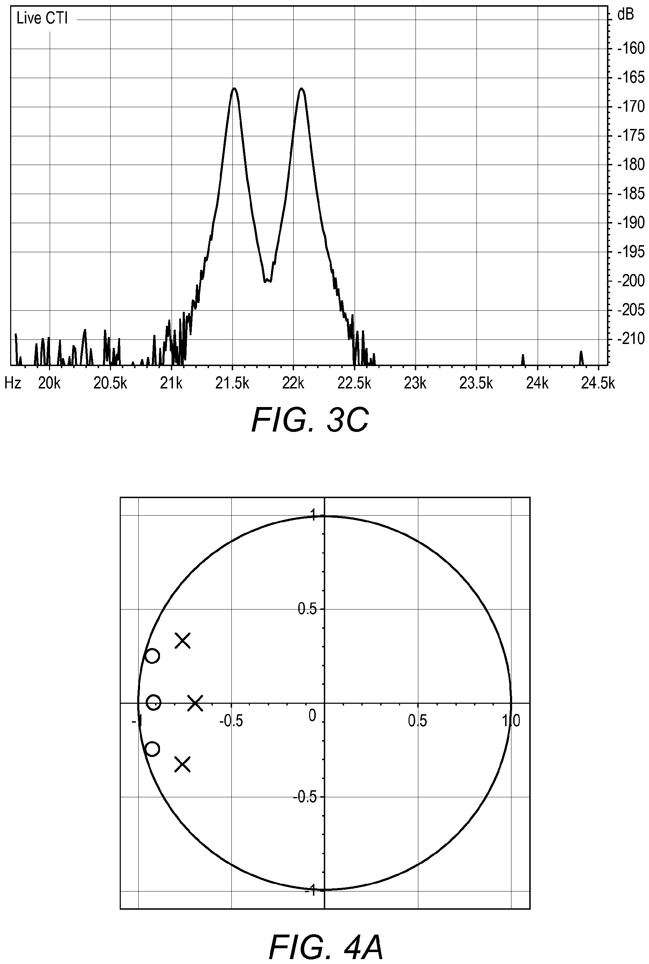

The Adobe plot is in fact the output of 'Adobe Audition 1.5' when upsampling a single impulse in a 44.1kHz stream to 88.2kHz, with the "Pre/Post Filter" and "Quality=999" options selected. Investigation reveals that the same filter is used internally when Audition is used to downsample from 88.2 kHz to 44.1 kHz. In the far 'tail' of the pre-response, figure 3B, we see a 'beating' effect and on taking a windowed Fourier transform of the tail, figure 3C we see two distinct frequencies, 21.5kHz and 22.05 kHz, corresponding approximately to the two edges of the transition band.

To remove the Audition filter's pre-ring a double-notch filter might therefore be indicated but this would be specific to the Audition 1.5 SRC. We desire a more general method since a music archive may contain 44.1 kHz recordings made and/or downsampled using diverse and possibly unknown equipment.

*Pre-response Suppression by Filtering*

Assuming pre-responses may have energy in the range 20 kHz-22.05 kHz, one approach is to attenuate this frequency range. A third order IIR filter having the following z-transform response:

$$\frac{(\,1.0443\,z + 0.9576\,)(\,1.0447\,z^2 + 1.9309\,z + 0.9572\,)}{(\,1.2039\,z + 0.8307\,)(\,1.2096\,z^2 + 1.8335\,z + 0.8267\,)}$$

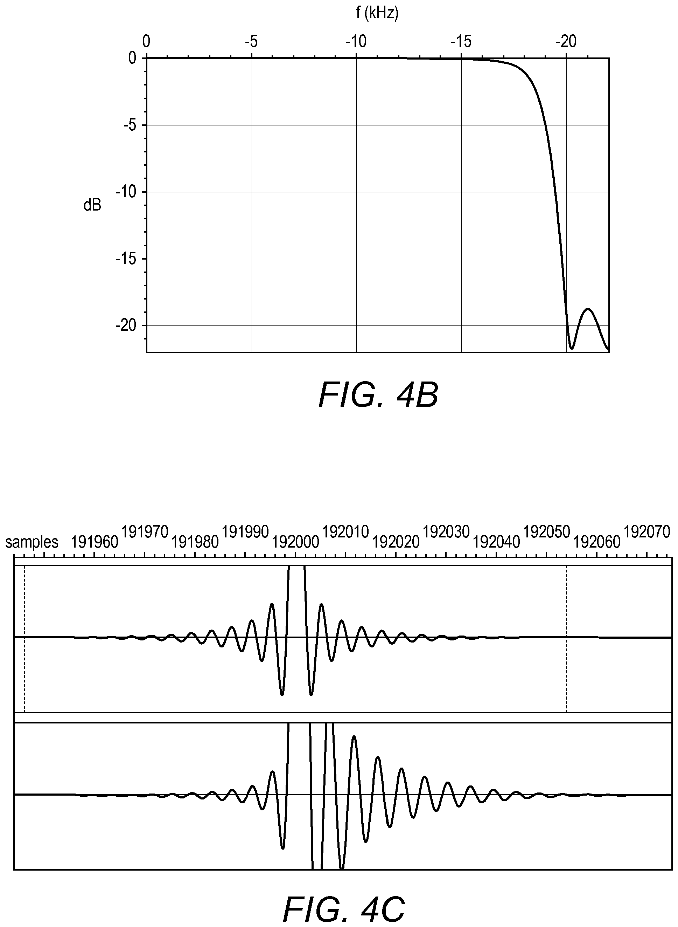

attenuates the region 20kHz-22.05kHz by 20dB when operated at a 44.1kHz sample rate. This IIR filter has poles (crosses) and zeroes (circles) as shown in figure 4A and the frequency response shown in figure 4B. Figure 4C shows the Arcam response to a single impulse and to an impulse pre-processed using the above filter. It will be seen that the processing has reduced the pre-response significantly, at the expense of a larger post-response and a frequency response droop of 1dB at 18 kHz.

According to the invention, the pre-responses may be further reduced by replacing the minimum-phase filter shown above by the corresponding maximum-phase filter, as follows:

$$\frac{(\,1.0443 + 0.9576\,z\,)(\,1.0447 + 1.9309\,z + 0.9572\,z^2\,)}{(\,1.2039\,z + 0.8307\,)(\,1.2096\,z^2 + 1.8335\,z + 0.8267\,)}$$

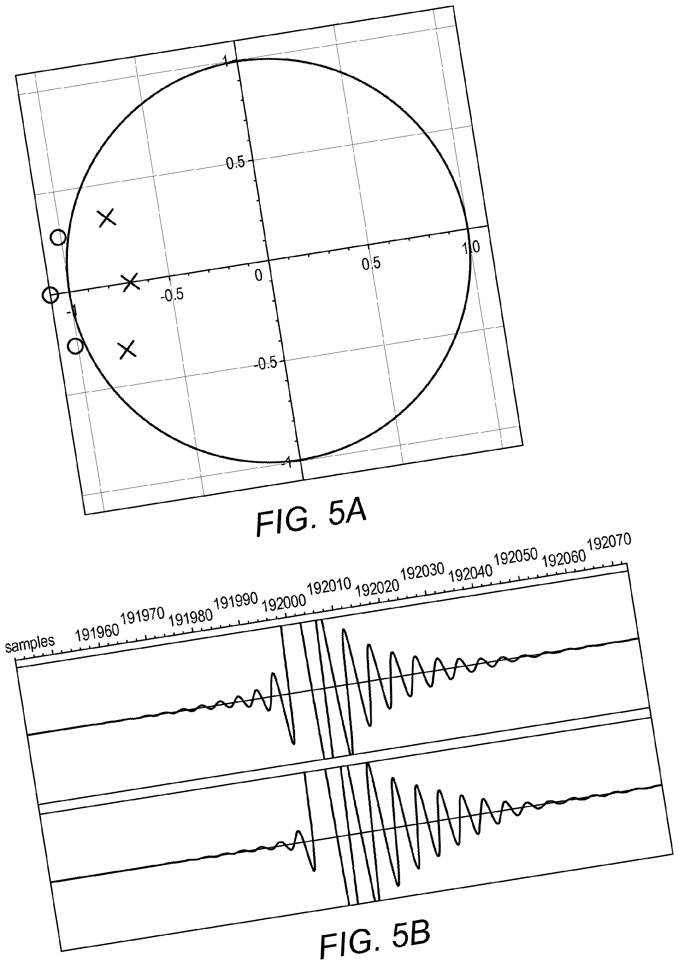

This filter has the same poles but with zeroes outside the unit circle, as shown in figure 5A. The frequency response is unchanged from the response shown in figure 4B. Figure 5B compares the two responses on a 10× expanded vertical scale, showing that the maximum-phase filter reduces the downswing immediately prior to the main impulse by 4dB relative to the minimum-phase filter and it reduces the other pre-responses by 6dB or more.

With zeroes outside the unit circle, it is now possible to adjust the poles inside the unit circle so as to create an all-pass filter:

$$\frac{(\,1.0443 + 0.9576\,z\,)(\,1.0447 + 1.9309\,z + 0.9572\,z^2\,)}{(\,1.0443\,z + 0.9576\,)(\,1.0447\,z^2 + 1.9309\,z + 0.9572\,)}$$

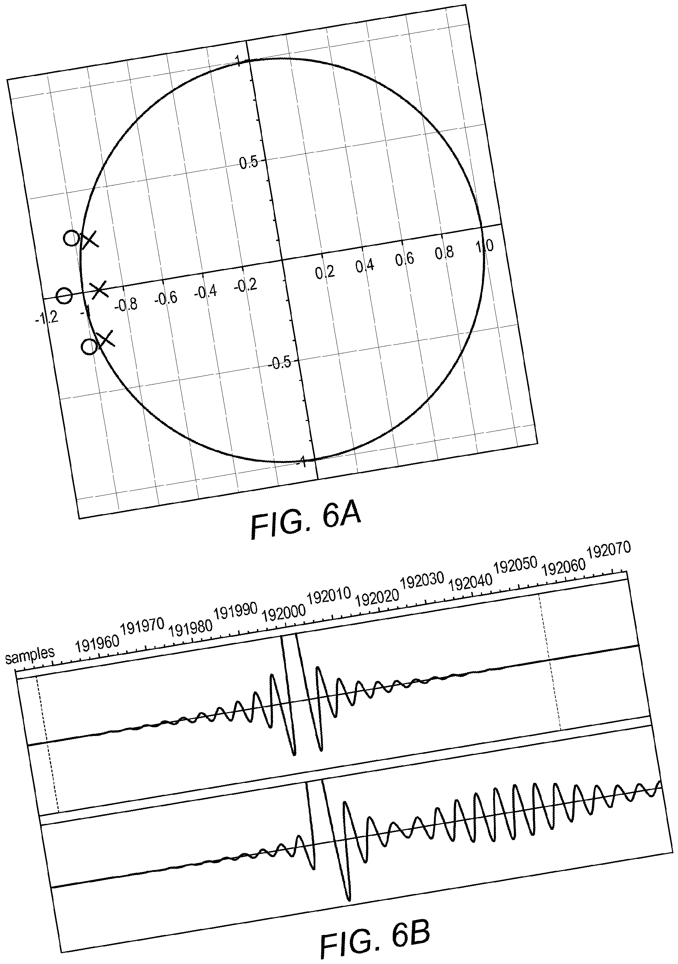

whose poles and zeroes are shown in figure 6A. This filter has a flat frequency response from zero to the Nyquist frequency, a property that some authorities would consider highly desirable. Figure 6B shows that this filter is able to reduce pre-responses significantly even though it provides no attenuation at pre-responses frequencies.

More powerful suppression of pre-responses is provided by a 12th order all-pass filter, as follows:

$$\left( \frac{1 + 1.84\, z + 0.85\, z^2}{z^2 + 1.84\, z + 0.85} \right) \left( \frac{1 + 1.81\, z + 0.84\, z^2}{z^2 + 1.81\, z + 0.84} \right) \left( \frac{1 + 1.75\, z + 0.81\, z^2}{z^2 + 1.75\, z + 0.81} \right)$$

$$\times \left( \frac{1 + 1.33\, z + 0.48\, z^2}{z^2 + 1.33\, z + 0.48} \right) \left( \frac{1 + 0.80\, z + 0.19\, z^2}{z^2 + 0.80\, z + 0.19} \right) \left( \frac{1 + 0.24\, z + 0.02\, z^2}{z^2 + 0.24\, z + 0.02} \right)$$

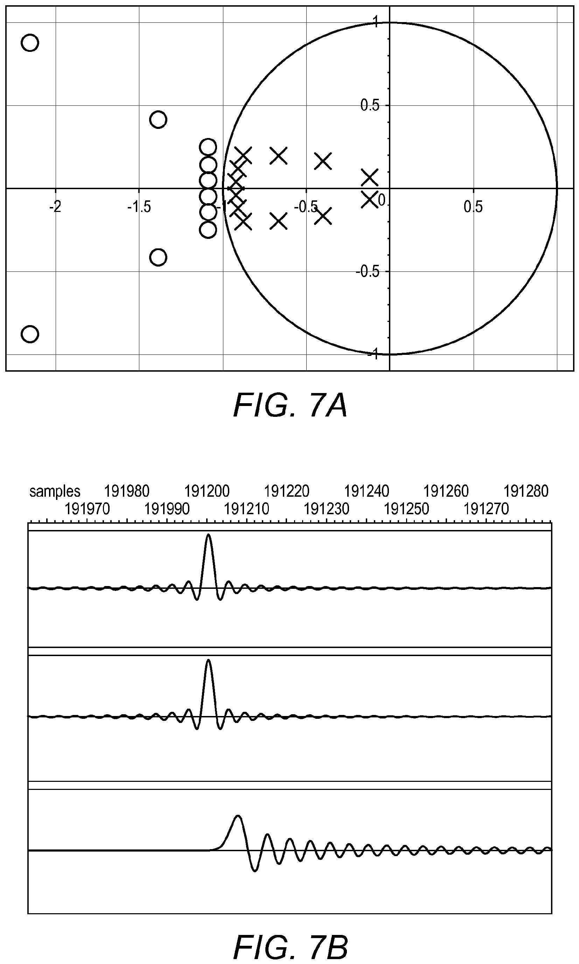

whose poles and zeroes are shown in Figure 7A.

Referring to figure 7B, the top trace shows the impulse response of the 'Adobe Audition 1.5' filter alone while the middle trace folds in the response of the Arcam FMJ DV139 player in an attempt to model a signal chain such as that shown in figure 1. The rings far from the central peak are attributable to the sharp transition band of the Audition filter and folding in the Arcam response reduces them slightly because of its -6dB attenuation at the Nyquist frequency.

The bottom trace of figure 7B includes the effect of processing the 44.1 kHz signal with the 12th order all-pass filter above. The pre-responses have been almost completely removed. This processing has been found to provide a substantial audible improvement on many commercially-issued recordings.

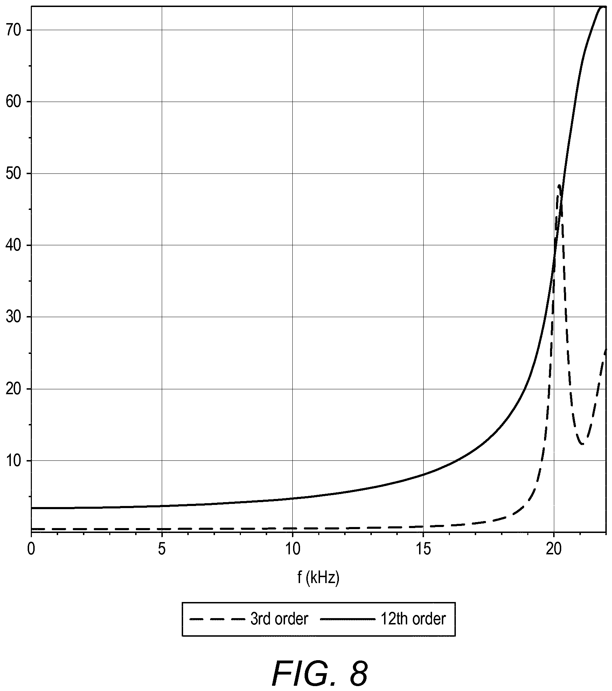

Figure 8 shows the group delays of the all-pass filters of figure 6A (3rd order) and figure 7A (12th order). Recalling from figure 3C that the spectral energy of the pre-responses lies mainly above 20kHz, the plots of figure 8 strongly suggest that the action of these all-pass filters is to delay the pre-responses, thus converting them into post-responses.

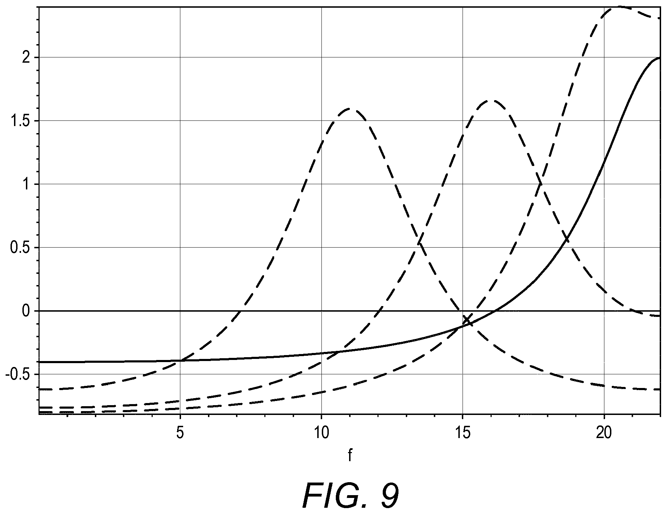

To measure pre-response delay a reference is needed, since a modest delay of the total signal does not affect the audio quality. One may conjecture that the ear may use as reference the highest peak in a filtered impulse response or a filtered envelope response. In practice it is found that non-mimimum-phase zeroes each having a larger group delay in the vicinity of 20 kHz than at low audio frequencies are helpful. We note that group delay at a frequency of 0Hz is well-defined mathematically: the group delay versus frequency of non-mimimum-phase zeroes having various frequencies over the range 11.025 kHz-22.1 kHz are plotted in figure 9. It will be seen that the group delay near 0 Hz is negative.

Referring again to figure 7A, it can be conjectured that the two pole-pairs closest to the origin, namely at $-0.12 \pm 0.06\, i$ and $-0.4 \pm 0.16\, i$ (where $i = \sqrt{-1}$), together with their corresponding zero-pairs at the reciprocal positions:

$$1\, /\, (-0.12 \pm 0.06\, i) = -6.46 \pm 3.43\, i$$

and

$$1\, /\, (-0.4 \pm 0.16\, i) = -2.15 \pm 0.87\, i$$

are contributing little to the group delay near 20 kHz relative to group delay at low audio frequencies. Calculation confirms that indeed these four zeroes and four poles can be deleted while affecting the said relative group delay by only 5% but saving 33% in filter complexity.

Thus in the case of all-pass filters, it is the poles whose real part is more negative than -0.5 together with their corresponding zeroes that are most helpful in delaying pre-responses close to the Nyquist frequency. In the case of filters that are not all-pass, it is the zeroes that are important since a zero can provide helpful attenuation even if there is no corresponding pole. Thus in general, it is the zeroes whose reciprocals lie inside the unit circle and whose real parts are more negative than - 0.5 that are most helpful in reducing pre-responses.

In some cases it is possible to deduce the presence of a non-minimum-phase zero in a filtering apparatus by feeding in a sine-wave with an exponentially rising envelope. For example, in the case of the filter represented in figure 6A, a sine-wave at a frequency of 20.2 kHz with envelope increasing by a factor of 1.045 on each sample period would theoretically produce zero output because of the zero at -1.0086 + 0.2723 $i$.

Of course, such a test signal must have a restricted duration in order not to provoke overload and care must be taken that processing delay is not mistaken for attenuation. A suitable test signal might start at a very low amplitude and contain an impulse as a time reference at the end of the increasing sine-wave. The test could include a comparison of the response to that signal with the response to a sine-wave at the same frequency but with constant amplitude. However, it is not practical to test for zeroes that are far outside the unit circle in this way and there may also be signal-to-noise difficulties in the case of zeroes that are extremely close to other zeroes. In difficult cases one may alternatively capture the impulse response of the apparatus to high precision using a technique such as chirp excitation, and then apply a root-finding algorithm to the impulse response.

In the situation depicted in figure 1, processing according to the invention may be placed either as P1 in the mastering equipment 5 or as P2 in the listener's receiving equipment 7. In both cases, pre-rings generated by the SRC 4 or by the listener's DAC 8 will be treated. Figure 7B provides a demonstration that pre-rings from both devices can be effectively suppressed in a single operation. When new recordings are released it would be obvious to place the treatment at P1 for the benefit of all listeners. Placement at P2 is however of value to listeners who may already have a collection of media 6 containing recordings that have not been treated.

The treatment has also been found useful for 'hi-res' recordings at a sample frequency such as 96 kHz which may contain pre-rings having frequencies closer to 48 kHz. The same filter architecture and coefficients have been used, but clocked at 96 kHz so that the large group delay is achieved at frequencies in the range 44 kHz to 48 kHz.

Separately from the above, it is sometimes required to treat a signal that has already been upsampled: for example there is evidence that some nominally 88.2 kHz or 96 kHz commercially available recordings have been upsampled from 44.1 kHz or 48 kHz respectively, thereby containing pre-responses just above 20kHz. In these cases we must distinguish between the sampling frequency of the signal presented for treatment and a 'reference' sampling frequency which relates to the process that created, or will subsequently create, the pre-rings it is desired to treat. Similar care is needed over the 'z-transform': for implementation purposes 'z' must represent a time advance of one sample of the signal presented for processing, but the criterion previously discussed relating to the positions of zeroes assumes a 'z' that represents one sample period of the process that produced or will produce a pre-response.

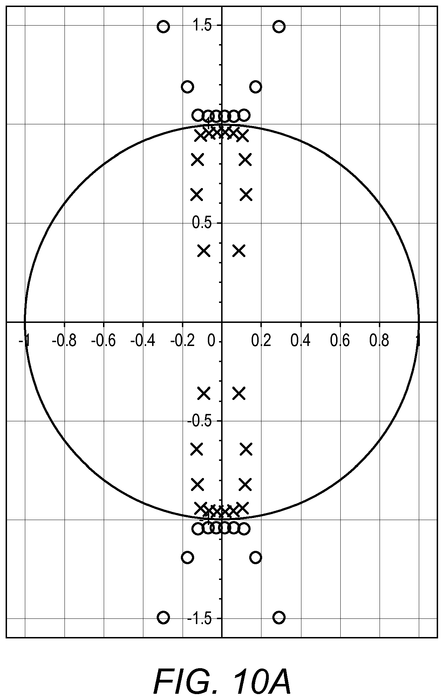

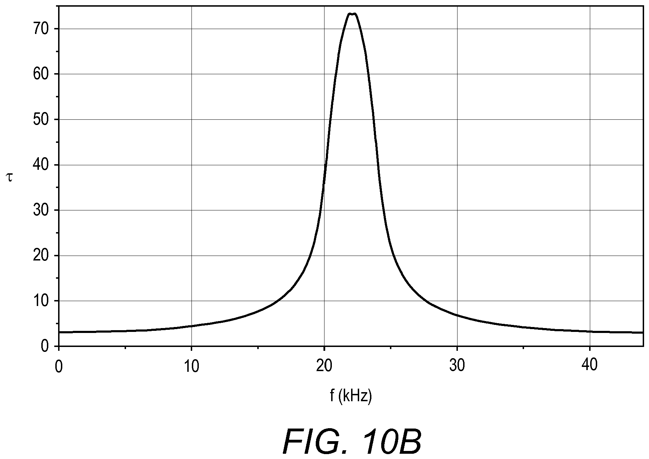

For the case where the reference sampling frequency is one-half of the signal's sampling frequency, an appropriate modification to the improvement filters already presented is to replace $z$ by $z^2$ throughout, and hence $z^2$ is replaced by $z^4$. The poles and zeroes shown in figure 7A are thereby replaced by those shown in figure 10A, and if the signal's sampling rate is 88.2 kHz then the group delay shown as the solid trace in figure 8 is extended by reflection about 22.05 kHz as shown in figure 10B.

The filters thus modified could alternatively be implemented by separate processing of substreams consisting of odd samples and even samples respectively, and this may be more economical.

These possibilities are not exhaustive, and although the processing will be performed digitally, it is not excluded that analogue media may intervene. For example, the archive 3 in figure 1 may be a library of analogue tapes, some of which may contain pre-responses because digital effects units operating internally at 44.1 kHz have been used to process the signal. As long as analogue media can be assumed linear, processing at the mastering stage 5 will be just as effective in suppressing these pre-responses as in an all-digital system.

**Claims**

1. A method of reducing a pre-response having energy at a pre-response frequency, the method comprising the step of filtering a digital audio signal using a digital non-minimum-phase filter (P1, P2) having a z-transform response that includes a zero lying outside the unit circle, wherein the zero is selected to create a greater group delay at the pre-response frequency than at a frequency of 0 Hz.

2. A method according to claim 1, wherein the digital audio signal contains the pre-response prior to the step of filtering.

3. A method according to claim 1 or claim 2, wherein the step of filtering preconditions the digital audio signal to reduce a pre-response that will be generated in a subsequent upsampling process.

4. A method according to any preceding claim, wherein the pre-response frequency lies within 20% of a reference Nyquist frequency equal to one half of a reference sampling frequency.

5. A method according to claim any preceding claim, wherein the z-transform response of the filter has at least three zeroes lying outside the unit circle, each selected such that it has a z-plane reciprocal whose real part is more negative than minus 0.5, wherein z represents a time advance of one sample at a reference sampling frequency.

6. A method according to claim 4 or claim 5, wherein the reference sampling frequency is the sampling frequency of the digital audio signal.

7. A method according to claim 4 or claim 5, wherein the reference sampling frequency is one half of the sampling frequency of the digital audio signal.

8. A method according to any preceding claim, wherein the z-transform response of the filter also includes a pole lying inside the unit circle at a reciprocal position to the zero, the pole and zero together selected to create an all-pass factor in the transfer function of the filter.

9. A method according to any of claims 1 to 7, wherein the filter comprises one or more zeroes and one or more poles configured such that the combination of zeroes and poles provides an amplitude response flat within 1dB over the frequency range 0 to 16 kHz.

10. A mastering processor (5) adapted to receive a first digital audio signal and to furnish a second digital audio signal for distribution, wherein the mastering processor is configured (P1) to perform the method of any one of claims 1 to 9 to reduce a pre-response in a signal rendered from the second signal for auditioning by a listener.

11. A consumer equipment (7) having an input adapted to receive a digital audio signal, the consumer equipment configured (P2) to process the received digital audio signal according to the method of any one of claims 1 to 9.

12. A recorded medium (6) conveying a digital audio signal processed by the method of any one of claims 1 to 9.

13. A computer program product comprising instructions that when executed by a signal processor causes said signal processor to perform the method of any of claims 1 to 9.


**Patentansprüche**

1. Verfahren zum Reduzieren einer Vorantwort mit Energie bei einer Vorantwortfrequenz, wobei das Verfahren den Schritt des Filterns eines digitalen Audiosignals unter Verwendung eines digitalen Nicht-Minimalphasenfilters (P1, P2) mit einer z-Transformationsantwort umfasst, die eine außerhalb des Einheitskreises liegende Nullstelle enthält, wobei die Nullstelle ausgewählt ist, um eine größere Gruppenverzögerung bei der Vorantwortfrequenz als bei einer Frequenz von 0 Hz zu erzeugen.

2. Verfahren nach Anspruch 1, wobei das digitale Audiosignal die Vorantwort vor dem Schritt des Filterns enthält.

3. Verfahren nach Anspruch 1 oder 2, wobei der Schritt des Filterns das digitale Audiosignal vorkonditioniert, um eine Vorantwort zu reduzieren, die in einem nachfolgenden Upsampling-Prozess erzeugt wird.

4. Verfahren nach einem der vorhergehenden Ansprüche, bei dem die Vorantwortfrequenz innerhalb von 20 % einer Referenz-Nyquist-Frequenz liegt, die gleich der Hälfte einer Referenzabtastfrequenz ist.

5. Verfahren nach einem der vorhergehenden Ansprüche, bei dem die z-Transformationsantwort des Filters mindestens drei Nullstellen aufweist, die außerhalb des Einheitskreises liegen und jeweils so gewählt sind, dass sie einen Reziprokwert der z-Ebene haben, dessen Realteil negativer als minus 0,5 ist, wobei z einen Zeitvorlauf von einem Abtastwert bei einer Referenzabtastfrequenz darstellt.

6. Verfahren nach Anspruch 4 oder Anspruch 5, wobei die Referenzabtastfrequenz die Abtastfrequenz des digitalen Audiosignals ist.

7. Verfahren nach Anspruch 4 oder Anspruch 5, wobei die Referenzabtastfrequenz die Hälfte der Abtastfrequenz des digitalen Audiosignals ist.

8. Verfahren nach einem der vorhergehenden Ansprüche, wobei die z-Transformationsantwort des Filters auch einen Pol enthält, der innerhalb des Einheitskreises bei einer reziproken Position zu der Nullstelle liegt, wobei der Pol und die Nullstelle zusammen ausgewählt sind, um einen Allpass-Faktor in der Übertragungsfunktion des Filters zu erzeugen.

9. Verfahren nach einem der Ansprüche 1 bis 7, wobei das Filter eine oder mehrere Nullstellen und einen oder mehrere Pole umfasst, die so konfiguriert sind, dass die Kombination von Nullstellen und Polen eine Amplitudenantwort innerhalb von 1 dB über den Frequenzbereich von 0 bis 16 kHz liefert.

10. Mastering-Prozessor (5), der angepasst ist, um ein erstes digitales Audiosignal zu empfangen und ein zweites digitales Audiosignal zur Verteilung bereitzustellen, wobei der Mastering-Prozessor konfiguriert ist (P1), um das Verfahren nach einem der Ansprüche 1 bis 9 auszuführen, um eine Vorantwort in einem Signal zu reduzieren, das von dem zweiten Signal zum Abhören durch einen Hörer gerendert wird.

11. Ein Verbrauchergerät (7) mit einem Eingang, der angepasst ist, um ein digitales Audiosignal zu empfangen, wobei das Verbrauchergerät (P2) konfiguriert ist (P2), das empfangene digitale Audiosignal gemäß dem Verfahren nach einem der Ansprüche 1 bis 9 zu verarbeiten.

12. Aufzeichnungsmedium (6), das ein digitales Audiosignal übermittelt, das durch das Verfahren nach einem der Ansprüche 1 bis 9 verarbeitet wurde.

13. Computerprogrammprodukt mit Anweisungen, die bei Ausführung durch einen Signalprozessor bewirken, dass der Signalprozessor das Verfahren nach einem der Ansprüche 1 bis 9 ausführt.


## Revendications

1. Procédé de réduction d'une préréponse ayant de l'énergie à une fréquence de préréponse, le procédé comprenant l'étape de filtrage d'un signal audio numérique utilisant un filtre numérique sans phase minimale (P1, P2) comportant une réponse à transformée en z qui comprend un zéro situé en dehors du cercle unitaire, le zéro étant choisi pour créer un plus grand retard de groupe à la fréquence de préréponse qu'à une fréquence nulle.

2. Procédé selon la revendication 1, dans lequel le signal audio numérique contient la préréponse avant l'étape de filtrage.

3. Procédé selon la revendication 1 ou la revendication 2, dans lequel l'étape de filtrage préconditionne le signal audio numérique pour réduire une préréponse qui sera produite lors d'un processus ultérieur de suréchantillonnage.

4. Procédé selon l'une quelconque des revendications précédentes, dans lequel la fréquence de préréponse se trouve à moins de 20 % d'une fréquence Nyquist de référence, égale à une moitié d'une fréquence d'échantillonnage de référence.

5. Procédé selon l'une quelconque des revendications précédentes, dans lequel la réponse à transformée en $z$ du filtre compte au moins trois zéros situés en dehors du cercle unitaire, chacun étant choisi de sorte qu'il ait un plan z réciproque, dont la partie réelle est inférieure à -0,5, z représentant une avance temporelle d'un échantillon à une fréquence d'échantillonnage de référence.

6. Procédé selon la revendication 4 ou la revendication 5, dans lequel la fréquence d'échantillonnage de référence est la fréquence d'échantillonnage du signal audio numérique.

7. Procédé selon la revendication 4 ou 5, dans lequel la fréquence d'échantillonnage de référence est une moitié de la fréquence d'échantillonnage du signal audio numérique.

8. Procédé selon l'une quelconque des revendications précédentes, dans lequel la réponse à transformée en z du filtre comprend un pôle situé à l'intérieur du cercle unitaire, à une position réciproque vis-à-vis de zéro, le pôle et le zéro étant choisis ensemble pour créer un facteur passe-tout dans la fonction de transfert du filtre.

9. Procédé selon l'une quelconque des revendications 1 à 7, dans lequel le filtre comprend au moins un zéro et au moins un pôle, configurés de sorte que la combinaison des zéros et des pôles donne un plat de réponse en amplitude à moins de 1 dB au-delà de la gamme de fréquence allant de 0 à 16 kHz.

10. Processeur de matriçage (5) adapté pour recevoir un premier signal audio numérique et pour fournir un second signal audio numérique pour distribution, le processeur de matriçage étant configuré (P1) pour mettre en oeuvre le procédé selon l'une quelconque des revendications 1 à 9 pour réduire une préréponse dans un signal rendu à partir du second signal pour une audition par un auditeur.

**11.** Équipement grand public (7) doté d'une entrée adaptée pour recevoir un signal audio numérique, l'équipement grand public étant configuré (P2) pour traiter le signal audio numérique reçu selon le procédé de l'une quelconque des revendications 1 à 9.

**12.** Support enregistré (6) de transmission d'un signal audio numérique traité par le procédé de l'une quelconque des revendications 1 à 9.

**13.** Produit de type programme informatique comprenant des instructions qui, quand elles sont exécutées par un processeur de signaux, amènent ledit processeur de signaux à réaliser le procédé selon l'une quelconque des revendications 1 à 9.

*FIG. 1*

*FIG. 2*

samples   191920 191940 191960 191980 192000 192020 192040 192060 192080 192100

FIG. 3A

samples  99100  99200  99300  99400  99500  99600  99700  99800  99900  100000      (clip)

FIG. 3B

FIG. 3C

FIG. 4A

FIG. 4B

FIG. 4C

FIG. 5A

FIG. 5B

FIG. 6A

FIG. 6B

FIG. 7A

FIG. 7B

FIG. 8

FIG. 9

FIG. 10A

FIG. 10B

**EP 3 029 674 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2014108677 A1
- US 5808574 A
- US 20090027117 A1

**Non-patent literature cited in the description**

- **J.R. STUART ; P.G. CRAVEN.** A Hierarchical Approach to Archiving and Distribution. *Audio Engineering Society Convention,* 11 October 2014
- **CRAVEN, P.G.** Antialias Filters and System Transient Response at High Sample Rates. *J. Audio Eng. Soc.,* March 2004, vol. 52 (3), 216-242